# EUROPEAN PATENT APPLICATION

(11) **EP 1 928 028 A1**
(43) Date of publication of application: **04.06.2008**
(21) Application number: 07121539.6
(22) Date of filing: 26.11.2007
(51) Int. Cl.: H01L 31/048, H01L 31/055, F24J 2/06

(54) **Photovoltaic roof tile system based on a fluorescent concentrator**

(30) Priority: 28.11.2006 US 605021
(71) Applicant: General Electric Company, Schenectady, NY 12345 (US)
(72) Inventor: Mayer, Oliver Gerhard, 81373, Muenchen (DE); Zettl, Marcus Alexander, 85653, Aying (DE); Stromberger, Joerg, 91186, Buechenbach (DE); Gonzalez, Omar Stern, 80805, Muenchen (DE)
(74) Representative: Bedford, Grant Richard

(57) **Abstract**

A solar roof tile system (10) is disclosed. The solar roof tile system (10) includes a fluorescence collector (26) having multiple edges (16) and configured to receive light (30) through a face (28) and configured to direct light (30) towards the edges (16) by total internal reflectance. The system (10) also includes a photovoltaic cell (24) coupled to at least one of the edges (16) and configured to receive the light (30) and convert the light (30) to electrical power. The system (10) further includes an optically matched interface layer (34) disposed between the fluorescence collector (26) and the photovoltaic cell (24) at the at least one edge (16).

## Description

The invention relates generally to photovoltaic or solar cells, and more particularly to, a system integrating photovoltaic cells into building elements such as roof tiles and façade elements.

Photovoltaic energy is becoming a significant source of electrical power. In addition to the use of stand-alone photovoltaic generators, roofs on residential and commercial buildings are well suited for mounting photovoltaic devices. To achieve widespread acceptance and use of photovoltaic devices on rooftops, they must satisfy aesthetic requirements, and thus must integrate in appearance and configuration with the conventional roof. Moreover, they must meet all the requirements of conventional roofing materials, including weather tightness, resistance to locally anticipated climatic conditions, as well as meeting local codes and conventions. Above and beyond the requirements for conventional roofing products, photovoltaic roofing materials must provide a means for electrical connections from unit to unit, and ultimately connection into the building.

Solar energy converters, such as photovoltaic converters, typically have high material cost, high installation cost and thus a high cost of energy produced (i.e., cost per kWh). One approach to reduce material cost is to concentrate solar irradiation (focus light) onto a photovoltaic cell by means of complex optical surface structuring. An emerging technique employs a fluorescence collector on a photovoltaic roof system that concentrates and guides absorbed light onto photovoltaic cells. However, it has been commonly observed that a significant amount of light escapes from the fluorescence collector without being directed on to the photovoltaic cells leading to reduction in the net collected energy. This reduces the efficiency of photovoltaic roof systems.

Therefore, it would be desirable to design an improved technique that would address the aforementioned problems.

In accordance with one aspect of the invention, a solar roof tile system is provided that includes a fluorescence collector having a plurality of edges and configured to receive light through a face and to direct light towards the edges by total internal reflectance. The system also includes a photovoltaic cell coupled to at least one of the edges and configured to receive the light and convert the light to electrical power. The system further includes an optically matched interface layer disposed between the fluorescence collector and the photovoltaic cell at the at least one edge.

In accordance with another aspect of the invention, a solar tile system is provided that includes a fluorescence collector having a plurality of edges and a plurality of slits configured to receive light through a face and to direct light towards the edges by total internal reflectance. The plurality of slits extends over a length less than the entire length of an adjacent edge. The system also includes a photovoltaic cell disposed in at least one of the slits and configured to receive the light and convert the light to electrical power. The system further includes an optically matched interface layer disposed between the fluorescence collector and the photovoltaic cell in the slit.

In accordance with another aspect of the invention, a method of assembling a solar roof tiling is provided. The method includes disposing an interface layer on at least one of a plurality of edges of a photovoltaic roof tile, the photovoltaic roof tile comprising a fluorescence collector configured to receive light through a face and to direct light towards the edges by total internal reflectance. The interface layer is optically matched with the fluorescence collector. The method also includes disposing a photovoltaic cell along the edge adjacent to the interface layer.

Various features, aspects, and advantages of the present invention will become better understood when the following detailed description is read with reference to the accompanying drawings in which like characters represent like parts throughout the drawings, wherein:
FIG. 1 is a perspective view of an undulated photovoltaic roof tile system in accordance with aspects of the invention;
FIG. 2 is a perspective view of the photovoltaic roof tile in FIG. 1 including an optically matched interface layer in accordance with an embodiment of the invention;
FIG. 3 is a partial sectional view of the photovoltaic roof tile in FIG. 1 in accordance with an embodiment of the invention;
FIG. 4 is a partial sectional view of the photovoltaic tile in FIG. 1 illustrating path of light incident upon the photovoltaic roof tile in accordance with an embodiment of the invention;
FIG. 5 is a cross-sectional view of an exemplary photovoltaic roof tile including a photovoltaic edge enclosure in accordance with an embodiment of the invention;
FIG. 6 is a perspective view of an alternative embodiment for a photovoltaic roof tile in accordance with an embodiment of the invention; and
FIG. 7 is a cross-sectional view of the photovoltaic roof tile in FIG. 6 including a photovoltaic edge enclosure in accordance with an embodiment of the invention; and
FIG. 8 is a flow chart representing steps in an exemplary method of assembling a photovoltaic roof tile system in accordance with an embodiment of the invention.

As discussed in detail below, embodiments of the present invention provide a photovoltaic roof tile system and a method of assembling the same. The photovoltaic roof tile system includes at least one photovoltaic cell attached to a fluorescence collector on a roof tile. The embodiments of the present invention disclose various modes of attachment of the photovoltaic cell with the roof tile. As used herein, the "fluorescence collector" includes a substrate and at least one particle dispersed in the substrate with an absorption spectrum to absorb light from a plurality of directions. In an example, the absorption spectrum may include more than one hundred nanometers. The absorbed light is typically emitted from the at least one particle to at least one edge of the fluorescence collector. Further details of a suitable fluorescence collector can be found in U.S. Patent Publication No. US 2006-0107993 A1 entitled "PHOTOVOLTAIC ROOF-TILE STRUCTURED ROOFING ELEMENT AND FACADE ELEMENT WITH FLUORESCENCE COLLECTOR", filed on Nov 19, 2004, which is assigned to the same assignee as the present invention, the entirety of which are hereby incorporated herein by reference herein.

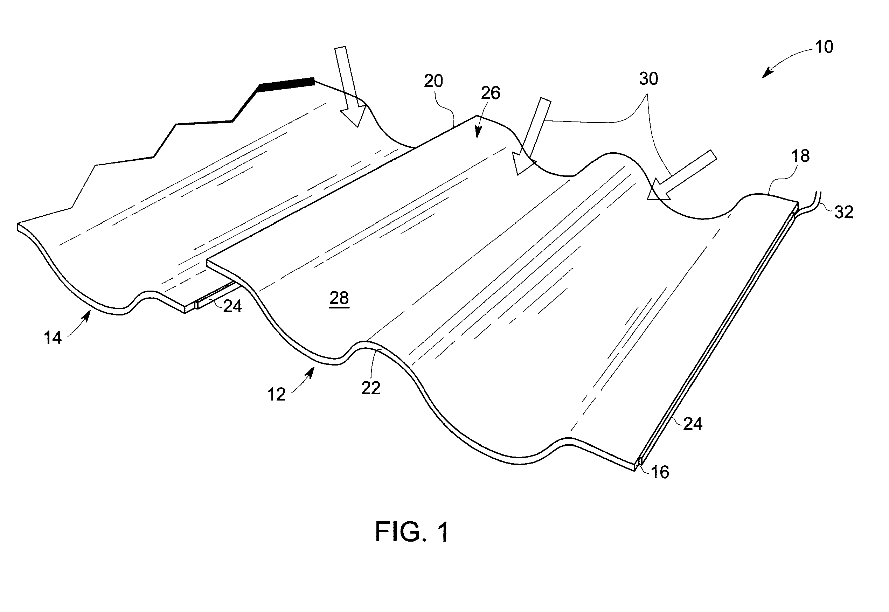

Turning now to the drawings, FIG. 1 is a perspective view of an exemplary photovoltaic roof tile system 10 in accordance with the invention. The photovoltaic roof tile system 10 includes overlapped undulated photovoltaic tiles 12 and 14 with multiple edges 16, 18, 20 and 22. The term "edges" used herein refers to an outer extremity of the photovoltaic tiles 12 and 14 respectively. The photovoltaic roof tile system 10 also includes at least one photovoltaic cell 24 coupled to at least one of the edges 16, 18, 20 and 22. In an exemplary embodiment of the invention, a photovoltaic cell 24 may be disposed on one of the edges 16. The photovoltaic tile system 10 also includes a fluorescence collector 26 on a top surface 28 configured to receive incident light 30 and direct the same towards the edges 16, 18, 20 and 22 via total internal reflection. The photovoltaic cell 24 may include leads 32 to provide a means for electrical connection to an electric panel, an electrical collection and distribution system, or the like (not shown). In an exemplary embodiment, the undulated tiles 12 and 14 may be overlapped such that edges with the photovoltaic cells 24 are covered so as to provide an attractive aesthetic appearance to the photovoltaic roof tile system 10. Some non-limiting examples of semiconductor material used in the photovoltaic cell 24 may include silicon, gallium arsenide, cadmium telluride, copper-indium sulphide, copper-indium-gallium-diselenide, amorphous silicon and microcrystalline silicon. To improve the intensity of incident light 30 reaching the photovoltaic cell 24 at the edge 16, a mirror (not shown) may be coupled to at least one of the other edges 18, 20 and 22 that are not coupled to a photovoltaic cell (e.g., to return light from such mirrored edges to the interior of the device until it reaches the photovoltaic cell).

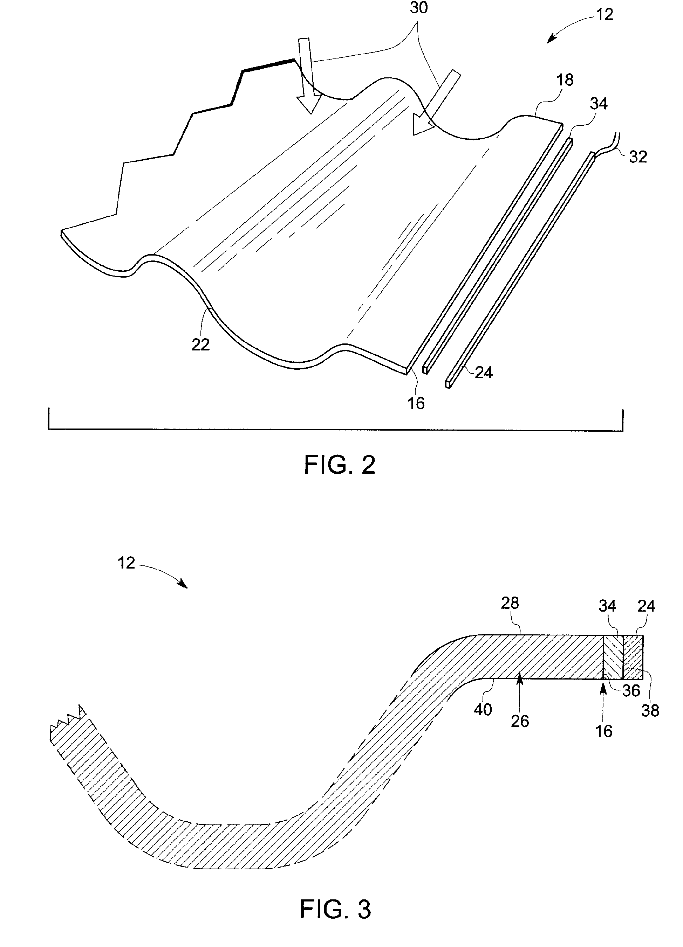

FIG. 2 is a perspective view of an undulated photovoltaic tile 12 as shown in FIG. 1 illustrating coupling of the photovoltaic cell 24 at the edge 16 in accordance with an aspect of the invention. The photovoltaic cell 24 is configured to receive light transmitted by total internal reflectance originating from the incident light 30 as referenced in FIG.1. To improve the intensity of the internal reflected rays on the photovoltaic cell 24, an optically matched interface layer 34 is disposed between the edge 16 and the photovoltaic cell 24. The interface layer 34 is optically matched such that light rays incident on the edge 16 are refracted into the interface layer 34 and further refracted into the photovoltaic cell 24. This results in an improved conversion efficiency of light into electrical power.

FIG. 3 is a partial sectional view of the photovoltaic tile 12 in FIG. 1. The edge 16 includes the optically matched interface layer 34 as referenced in FIG. 2 disposed between the fluorescence collector 26 as referenced in FIG.1 and the photovoltaic cell 24. Optical matching occurs at an interface 36 between the fluorescence collector 26 and the interface layer 34 and at an interface 38 between the interface layer 34 and the photovoltaic cell 24. In a particular embodiment, the refractive index of the optically matched interface layer 34 may be equal to about the square root of the product of the refractive index of the fluorescence collector 26 and the refractive index of the photovoltaic cell 24. Some non-limiting examples of material fluorescence collector 26 may include polycarbonate, ceramics, used in the polymethylmethacrylate and polystyrol. Some non-limiting examples of the optically matched interface layer 34 may be an optical gel, oil, an optical adhesive film, an optical transparent plate and glue. The thickness of the optically matched layer 34 may vary typically between about 0.01 mm and about 1 mm. In a presently contemplated embodiment, the thickness of layer of the photovoltaic cell 24 may vary between about 5 µm and about 1 mm.

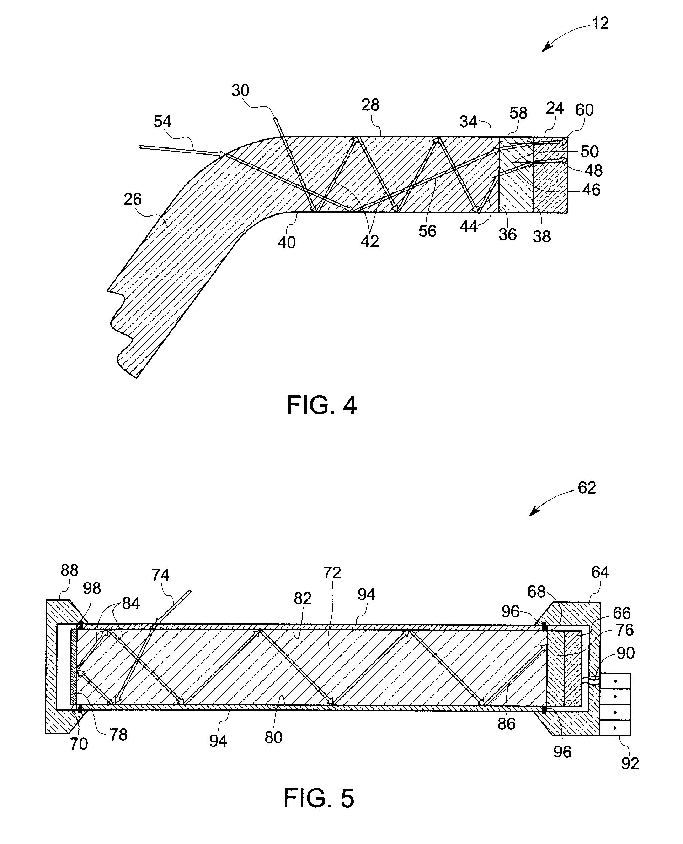

FIG. 4 is a partial sectional view of the photovoltaic tile 12 in FIG.1 illustrating total internal reflectance of the incident light 30 as referenced in FIG. 1 and optical matching via the optically matched interface layer 34 in FIG.2. In the illustrated example, incident light 30 as shown in FIG. 1 is transmitted by total internal reflectance between a bottom surface 40 of fluorescence collector 26 as referenced in FIG. 1 and a top surface 28 as referenced in FIG.1 of the fluorescence collector 26, as indicated by light ray 42. The light ray 42 is further reflected at the top surface 28 until it is finally incident on the edge 16, as indicated by light ray 44. The light ray 44 is refracted as ray 46 at the interface 36 as referenced in FIG. 3 between the fluorescence collector 26 and the optically matched interface layer 34 according to Snell's law of refraction. The refracted ray 46 is further incident upon the interface 38 as referenced in FIG. 3 between the optically matched interface layer 34 and the photovoltaic cell 24, as indicated by light ray 48. The light ray 48 is refracted such that angle of incidence from a normal 50 to the interface 38 is nearly equal to the angle of refraction from the normal due to optical matching. Similarly, in another embodiment, an incident light ray 54 may be totally internally reflected to be incident upon the interface 36, as indicated by light ray 56. The light ray 56 may be refracted through the optically matched interface layer 34 as light ray 58 and further refracted through the photovoltaic cell 24 as light ray 60.

FIG. 5 is a cross-sectional view of an exemplary photovoltaic tile 62 in accordance with an embodiment of the invention, including a photovoltaic edge enclosure 64 to provide protection to a photovoltaic cell 66. The photovoltaic tile 62 includes opposing edges 68 and 70, respectively. The photovoltaic tile 62 also includes a fluorescence collector 72 configured to totally internally reflect incident light 74 towards the edges 68 and 70. The photovoltaic cell 66 may be coupled to the fluorescence collector 72 at the edge 68 via an optically matched interface layer 76. As discussed above, the optically matched interface layer 76 provides optical matching between the fluorescence collector 72 and the photovoltaic cell 66 as described with reference to FIG. 4. The photovoltaic tile 62 may also include a mirror 78 coupled to the edge 70. The mirror 78 provides additional reflection for the incident light 74 to enhance the efficiency of the photovoltaic tile 62.

For an example, the incident light 74 may be totally internally reflected at a bottom surface 80 and a top surface 82, and returned by each of the mirrored edges 70, leading to a series of totally internally reflected light rays 84 and finally resulting in a light ray 86 incident upon the photovoltaic cell 66 at the edge 68. The photovoltaic edge enclosure 64 may encompass the photovoltaic cell 66 such that the photovoltaic cell 66 may be protected from extreme weather conditions and other environmental impacts. The photovoltaic edge enclosure 64 also provides mechanical protection to the photovoltaic cell 66. Similarly, a mirror edge enclosure 88 may encompass the mirror 78 to provide protection. The photovoltaic cell 66 may include leads 90 passing through a junction box 92 as a means for electrical connection. A coating 94 may be provided on the bottom surface 80 and the top surface 82 to protect the photovoltaic tile 62 from harmful ultraviolet rays. The photovoltaic edge enclosure 64 may be clamped via clamps 96 to the top surface 82 of the fluorescence collector 72 and the bottom surface 80 of the fluorescence collector 72. Similarly, the mirror edge enclosure may be clamped via clamps 98 to the top surface 82 and the bottom surface 80 of the fluorescence collector 72.

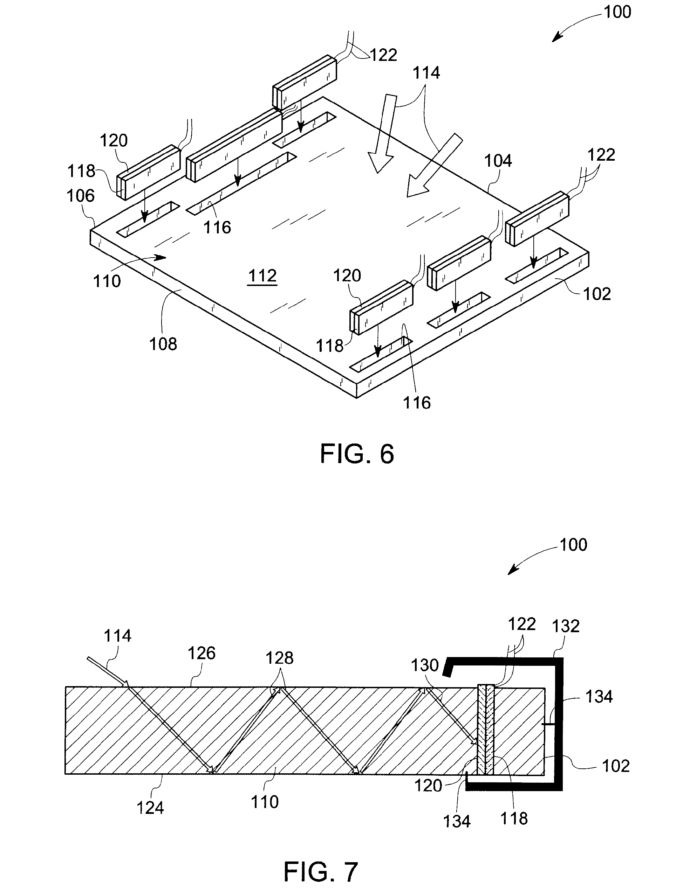

FIG. 6 is a perspective view of another exemplary embodiment of a photovoltaic tile 100 with multiple edges 102, 104, 106 and 108. The photovoltaic tile 100 may include a fluorescence collector 110 on a top surface 112 configured to receive incident light ray 114 through the top surface 112 and direct the incident light ray 114 towards the edges 102, 104, 106 and 108 by means of total internal reflectance. The photovoltaic tile 100 further includes multiple slits 116 on a top surface 112 of the fluorescence collector 110 adjacent to the edges 102, 104, 106 and 108. In an example, the slits 116 are adjacent to the edge 102 and the edge 106. In a presently contemplated embodiment, the length of the slits 116 is less than length of any of the edges 102, 104, 106 and 108. In another embodiment, a second row of slits 116 may be disposed to overlap a gap between the slits 116 in a first row adjacent to the edge 106. This reduces loss of light through a gap between the slits 116. Further, it increases mechanical strength of the photovoltaic tile 100. A photovoltaic cell 118 may be disposed into at least one of the slits 116 adjacent to an optically matched interface layer 120.

The optically matched interface layer 120 provides optical matching between the photovoltaic cell 118 and the fluorescence collector 110 thus enhancing the overall efficiency of the photovoltaic tile 100. In a particular embodiment, refractive index of the optically matched interface layer 120 is about the square root of the product of the refractive index of the fluorescence collector 110 and the refractive index of the photovoltaic cell 118. Further, the optically matched interface layer 120 may act as an adhesive for gluing the photovoltaic cells 114 into the slits 112. The photovoltaic cell 118 may include leads 122 as a means for electrical connection.

FIG. 7 is a partial sectional view of the photovoltaic tile 100 in FIG. 6. The photovoltaic tile 100 includes the fluorescence collector 110 as referenced in FIG. 6 configured to direct incident light 114 as shown in FIG. 6 towards an optically matched interface layer 120 adjacent to the edge 102. The incident light 114 may be totally internally reflected at a bottom surface 124 and a top surface 126, leading to a series of light rays 128 and finally incident upon the optically matched interface layer 120 as light ray 130. The photovoltaic cell 118, as referenced in FIG. 6, is disposed adjacent to the optically matched interface layer 120. The optically matched interface layer 120 is disposed between the fluorescence collector 110 and the photovoltaic cell 118. A photovoltaic edge enclosure 132 may be disposed around the photovoltaic cell 118 in order to provide protection from extreme weather conditions and other environmental impacts. The photovoltaic edge enclosure 132 may also provide mechanical protection to the photovoltaic cell 118. The photovoltaic edge enclosure 132 may be clamped via clamps 134 to the bottom surface 124 of the fluorescence collector 110 and the edge 102 of the florescence collector 110. This helps in avoiding any interference to total internal reflectance of the incident light 114.

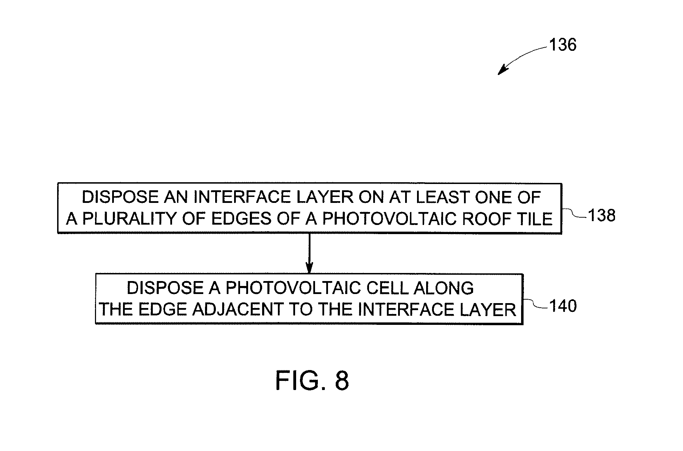

FIG. 8 is a flow chart representing steps in an exemplary method 136 of assembling a photovoltaic roof tile system. The method 136 includes disposing an interface layer on at least one of the multiple edges of a photovoltaic roof tile in step 138. In an exemplary embodiment, the interface layer may be disposed in at least one of the slits adjacent to at least one of the multiple edges of the photovoltaic roof tile. A photovoltaic cell may be disposed along the edge adjacent to the interface layer in step 140. In a particular embodiment, the interface layer and the photovoltaic cell may be disposed in at least one of multiple slits adjacent to at least one of the multiple edges of the photovoltaic roof tile. In another embodiment, a photovoltaic edge enclosure may be disposed around the photovoltaic cell for mechanical protection and for protection from extreme weather conditions. In yet another embodiment, a mirror may be disposed on at least one of the edges not coupled to the photovoltaic cell.

While only certain features of the invention have been illustrated and described herein, many modifications and changes will occur to those skilled in the art. It is, therefore, to be understood that the appended claims are intended to cover all such modifications and changes as fall within the true spirit of the invention.

## Claims

1. A solar tile system (10) comprising:
a fluorescence collector (26) having a plurality of edges (16) and configured to receive light through a face (28) and to direct light (30) towards the edges (16) by total internal reflectance;
a photovoltaic cell (24) coupled to at least one of the edges (16) and configured to receive the light (30) and convert the light (30) to electrical power; and
an optically matched interface layer (34) disposed between the fluorescence collector (26) and the photovoltaic cell (24) at the at least one edge (16).

2. The system (10) of claim 1, wherein the at least one edge (16) comprises an outer extremity of a solar tile (12).

3. The system (10) of claim 1 or claim 2, wherein the at least one edge (16) comprises an edge (16) defined by a slit (116) in the fluorescence collector (26).

4. The system (10) of preceding claim, wherein the optically matched interface layer (34) comprises an optical gel, oil, an optical adhesive film, an optical transparent plate or glue.

5. The system (10) of any preceding claim, wherein the optically matched interface layer (34) has a refractive index equal to about the square root of the product of the refractive index of the fluorescence collector (26) and the refractive index of the photovoltaic cell (24).

6. A solar tile system (100) comprising:
a fluorescence collector (110) having a plurality of edges (102) and a plurality of slits (116) configured to receive light (114) through a face (112) and to direct light (114) towards the edges (102) by total internal reflectance, wherein the plurality of slits (116) extends over a length less than the entire length of an adjacent edge;
a photovoltaic cell (118) disposed in at least one of the slits (116) adjacent to one of the edges (102) and configured to receive the light (114) and convert the light (114) to electrical power; and
an optically matched interface layer (120) disposed between the fluorescence collector (110) and the photovoltaic cell (118) at the at least one slit (116).

7. The system (100) of claim 6, wherein the optically matched interface layer (120) comprises an optical gel, oil, an optical adhesive film, an optical transparent plate or glue.

8. The system (100) of claim 6 or claim 7, wherein the optically matched interface layer (120) has a refractive index equal to about the square root of the product of the refractive index of the fluorescence collector (110) and the refractive index of the photovoltaic cell (118).

9. A method (136) of assembling a solar roof tiling comprising:
disposing an interface layer (138) on at least one of a plurality of edges of a photovoltaic roof tile, the photovoltaic roof tile comprising a fluorescence collector configured to receive light through a face and to direct light towards the edges by total internal reflectance, the interface layer being optically matched with the fluorescence collector; and
disposing a photovoltaic cell (140) along the edge adjacent to the interface layer.

10. The method (136) of claim 9, wherein disposing an interface layer (136) comprises disposing an interface layer into at least one of a plurality of slits adjacent to at least one of the plurality of edges of the photovoltaic roof tile.
